(19) Europäisches Patentamt
European Patent Office
Office européen des brevets

(11) **EP 1 332 594 B1**

(12) **EUROPÄISCHE PATENTSCHRIFT**

(45) Veröffentlichungstag und Bekanntmachung des Hinweises auf die Patenterteilung:
**24.02.2010 Patentblatt 2010/08**

(21) Anmeldenummer: **01987989.9**

(22) Anmeldetag: **16.10.2001**

(51) Int Cl.:
***H04L 27/00*** *(2006.01)*

(86) Internationale Anmeldenummer:
**PCT/DE2001/003914**

(87) Internationale Veröffentlichungsnummer:
**WO 2002/033922 (25.04.2002 Gazette 2002/17)**

(54) **VERFAHREN UND VORRICHTUNG ZUR ERFASSUNG UND VERARBEITUNG VON SIGNALWELLEN**

METHOD AND DEVICE FOR THE RECORDING AND PROCESSING OF SIGNAL WAVES

PROCEDE ET DISPOSITIF D'ENREGISTREMENT ET DE TRAITEMENT D'ONDES PORTEUSES D'INFORMATION

(84) Benannte Vertragsstaaten:
**AT BE CH CY DE DK ES FI FR GB GR IE IT LI LU MC NL PT SE TR**

(30) Priorität: **16.10.2000 PCT/DE00/03632**

(43) Veröffentlichungstag der Anmeldung:
**06.08.2003 Patentblatt 2003/32**

(73) Patentinhaber: **PMDTechnologies GmbH**
**57076 Siegen (DE)**

(72) Erfinder: **Swcharte, Rudolf**
**57250 Netphen (DE)**

(74) Vertreter: **Weber, Roland et al**
**WSL Patentanwälte**
**Postfach 6145**
**65051 Wiesbaden (DE)**

(56) Entgegenhaltungen:
**DE-A- 4 328 553    DE-A- 4 439 298**
**DE-A- 19 704 496    DE-A- 19 821 974**

- **R. SCHWARTE: "NEW ELECTRO-OPTICAL MIXING AND CORRELATING SENSOR : FACILITIES AND APPLICATIONS OF THE PHOTONIC MIXER DEVICE (PMD)electr" PROCEEDINGS OF THE SPIE , SPIE, BELLINGHAM,US,, Bd. 3100, 1. Januar 1997 (1997-01-01), Seiten 245-253, XP002080273 BELLINGHAM , US**
- **SCHWARTE: "NEUARTIGE 3D-VISIONSYSTEME AUF DER BASIS LAYOUT-OPTIMIERTER PMD-STRUKTUREN" TECHNISCHES MESSEN TM,, Bd. 65, Nr. 7/8, 1. Juli 1998 (1998-07-01), Seiten 264-271, XP000847213 MUNCHEN,DE**

**Beschreibung**

Die vorliegende Erfindung betrifft ein Verfahren zur Erfassung und zur Verarbeitung der Amplitude und Phase von Signalwellen, wobei eine Signalquelle eine modulierte Signalwelle erzeugt, die auf ihrem Weg durch ein Übertragungsmedium bzw. durch ein Objekt aufgrund von Reflexion und/oder Streuung verändert, von einer Empfangseinrichtung empfangen und dort mit einem Modulationssignal, das in einer wohldefinierten Beziehung zu der Modulation der Signalwelle steht, durch eine Modulationsvorrichtung (PMD, MMD) ohne den Träger der Signalwelle direkt demoduliert und bezüglich der Amplitude der modulierten Signalwelle und der Phasenbeziehung der Modulationsphase der Signalwelle und des Modulationssignals erfaßt und ausgewertet wird, wobei in einem auf die Signalwelle empfindlichen Sensor einer Empfangseinrichtung durch die Signalwellenenergie unmittelbar oder mittelbar erzeugte Wellenenergieteilchen in einem Schaukelprozeß mit einer Wellenenergieschaukel nach Maßgabe des Modulationssignals auf mindestens zwei unterscheidbare Gruppen von Aufnahmeelementen des Sensors geleitet, erfaßt, gegebenenfalls verstärkt und auf mindestens einem den Gruppen von Aufnahmeelementen entsprechenden Auslese-Ausgang einer Ausleseeinheit als Summen- und/oder Korrelationssignal ausgegeben werden.

Ebenso betrifft die vorliegende Erfindung eine Vorrichtung zur Erfassung und zur Verarbeitung der Amplitude und Phase von Signalwellen, mit einer Signalquelle, die eine modulierte Signalwelle erzeugt, einer Empfangseinrichtung für die auf ihrem Weg durch ein Übertragungsmedium bzw. durch ein Objekt aufgrund von Reflexion und/oder Streuung veränderte Signalwelle, einer Modulationsvorrichtung der Empfangseinrichtung, welche mit einem Modulationssignal, das in einer wohldefinierten Beziehung zu der Modulation der Signalwelle steht, beaufschlagt wird, einem auf die Signalwellen empfindlichen Sensor der Empfangseinrichtung, in welchem durch die Signalwellenenergie unmittelbar oder mittelbar Wellenenergieteilchen erzeugt werden, wobei die Modulationsvorrichtung dafür ausgelegt ist, die Wellenergieteilchen in einem Schaukelprozeß mit einer Wellenenergieschaukel nach Maßgabe des Modulationssignals auf mindestens zwei Gruppen von Aufnahmeelementen des Sensors zu leiten, und mit mindestens einem entsprechenden Auslese-Ausgang einer Ausleseeinheit, für die Ausgabe eines Summen- und/oder Korrelationssignals.

Ein entsprechendes Verfahren und eine entsprechende Vorrichtung sind aus der DE 196 35 932.5 bekannt. Die durch die einfallende modulierte Lichtwelle im PMD generierten Photoladungen werden nach diesem Stand der Technik mit Hilfe mindestens zweier Photogates einem demodulierenden Schaukelprozeß ausgesetzt und im Gegentakt ausgelesen und ausgewertet, wodurch Aufwand und Größe des Empfängers gegenüber vorher bekannten Vorrichtungen ähnlicher Wirkung um Größenordnungen reduziert werden, was den Aufbau eines 3D-bildgebenden Arrays aus vielen pixelartigen Empfängern ermöglicht. Trotz dieser außergewöhnlichen Fortschritte weisen derartige PMD-Pixelempfänger Möglichkeiten zur Verbesserung auf.

Eine wichtige technische Aufgabenstellung in der Industrieproduktion und Automatisierung, im Straßenverkehr, in der Sicherheitstechnik und vielen weiteren Bereichen besteht darin, über die Ausbreitung von Signalwellen, d. h. berührungslos mittels Wellenausbreitung Informationen über transmittierte und reflektierte Signalwellen zu erlangen. Messsysteme für derartige Aufgabenstellungen sind seit langem bekannt, insbesondere Laserradars für optische Signalwellen, Mikrowellenradars für Mikrowellen und Computer-Tomographen für Röntgenwellen. Für selbst erzeugte Signalwellen wird die Signalquelle in geeigneter Weise moduliert. Durch geeignete Demodulation der transmittierten und reflektierten Signalwellen können Objektinformationen gewonnen werden. Die zugehörigen Empfangseinrichtungen sind sehr aufwendig und enthalten im Allgemeinen nur einen Empfänger. Um dennoch viele Messpunkte der Signalwelle zu vermessen, verwenden sie einen Scanner. Der Stand der Technik für optische Signalwellen wird z. B. in"Computer Vision" Band I, Academic Press, ISBN o-12-379771-3 auf S. 474ff beschrieben. Dort wird eine neuartige Lösung zur Vereinfachung der Phasen-bzw. Laufzeitmessung eines des optischen Empfängers beschrieben, der sog. Photomischdetektor oder "Photonic Mixer Device" (PMD), der erstmals in der oben erwähnten DE 196 35 932.5 beschrieben wird.

Die für die inhärente Modulation des PMD notwendigen Photogates verursachen eine Dämpfung des einfallenden Lichts außerdem wird das modulierende elektrische Driftfeld nicht optimal in Flussrichtung der Photoladung eingebracht. Die Modulationsbandbreite der Modulation der Photostromverteilung mittels dieser Modulationsphotogates ist praktisch auf etwa 1 GHz beschränkt.

Aus der Veröffentlichung Schwarte: "Neuartige 3D-Visionssysteme auf der Basis Layoutoptimierter PMD-Strukturen" Technisches Messen TM, Bd. 65, Nr. 7/8, 1. Juli 1998, Seiten 264-271, sind PMD-Chips für Laufzeit-Zeilenkameras und Laufzeit-Matrixkameras auf Basis von CMOS-Technologie bekannt. Die darin beschriebene PMD-Elemente weisen voneinander getrennte Modulationsgates und Ausleseelektroden auf.

Gesucht sind neue Lösungen für Photomischdetektoren ohne Modulationsphotogates mit insbesondere höherer Modulationsbandbreite, höherer Genauigkeit und höherer Empfindlichkeit.

Dieser Erfindung liegt die Aufgabe zugrunde, ein Verfahren und eine Vorrichtung der eingangs genannten Art anzugeben, die für die aufgeführten Signalwellen neuartige vorteilhafte PMD-Empfängerprinzipien verwenden, und PMD-Sensoren mit verbesserten Eigenschaften, erweiterten Anwendungsbereichen und neuen Leistungsmerkmalen vorzuschlagen.

Die zuvor genannte Aufgabe wird durch ein Verfahren gemäß Anspruch 1 sowie eine Vorrichtung gemäß Anspruch 10 gelöst.

Der gesuchte flächenhafte Detektor für elektromagnetische Wellen soll in der Lage sein, mit möglichst hoher Zeitauflösung und Bandbreite codierte bzw. modulierte Signalwellen in ihrer Phase und Amplitude zu detektieren. Er sollte zugleich die Beeinträchtigung der Detektionseigenschaften durch das Modulationssignal selbst und ihm verbundene konstruktive Nachteile vermeiden. Er soll inhärent mit gleichzeitig hoher Mischsteilheit und hoher Bandbreite und Empfindlichkeit demodulieren, decodieren und wahlweise korrelieren. Dabei soll der korrelierte Signalwellenanteil der empfangenen Signalwelle extrem rauscharm und mit hoher Selektivität bestimmt werden, während der nichtkorrelierte Signalwellenanteil, z. B. Hintergrundstrahlung, weitestgehend zu unterdrücken ist.

Zur Lösung der Aufgabenstellung wird hinsichtlich des Verfahrens vorgeschlagen, dass mindestens eine der Gruppen von Aufnahmeelementen direkt mit dem Modulationssignal beaufschlagt wird.

Hinsichtlich der Vorrichtung wird die der Erfindung zugrunde Aufgabe dadurch gelöst, dass mindestens eine der Gruppen von Aufnahmeelementen unmittelbar mit der Modulationsvorrichtung verbunden ist.

Der Detektor wird zweckmäßigerweise in eine Mehrzahl kooperierender Detektorstreifen (Aufnahmeelemente) aufgeteilt, die eine sog. Fingerstruktur bilden, wobei die Einleitung des für die Mischung erforderlichen Modulationssignals nicht durch eine zusätzliche modulierende Fingerstruktur erfolgt, sondern wobei die Aufnahmeelemente selbst zur Einbringung des mindestens einen Modulationssignals dienen, Insbesondere bei Photodetektoren ist die Realisierung in einer Fingerstruktur zur Erzielung einer hohen Schaltgeschwindigkeit durch kurze Wege der Photoladungen und für die geforderte Flexibilität der Pixelgröße eine besonders wirkungsvolle Maßnahme.

Auch bei Mikrowellensignalen ist aufgrund der sehr kleinen Wellenlänge eine Mehrzahl von Aufnahmeelementen erforderlich, um eine hinreichend große Querschnittsfläche mit entsprechend großer Empfangsleistung zu erhalten. Hierzu dienen i. A. rechteck- bzw. fingerförmige Patchantennen, die aufgrund der Ausrichtung nach der Polarisation der Signalwellen eine Fingerstruktur bilden.

Als Signalwellen kommen nicht nur elektromagnetische Wellen des gesamten praktisch verfugbaren Spektrums vom Radiobereich bis in das ferne Ultraviolett, bei geeigneten Detektoren auch Röntgen oder Gammastrahlung in Betracht, sondern zum Beispiel auch akustische Wellen, insbesondere Ultraschallwellen.

Die "Wellenenergieteilchen" sind im Allgemeinen Elektronen und/oder Löcher. Sie können unmittelbar, zum Beispiel als Photoelektronen durch auf ein photoempfindliches Halbleitermaterial auftreffende Strahlung erzeugte werden oder mittelbar durch Ladungsverschiebung in Antennen durch z. B. Mikrowellen, oder in piezoelektrischen Materialien durch elektroakustische Wechselwirkung.

Aufnahmeelemente werden sind dementsprechend Elektroden bzw. Anschlüsse von Kondensatoren und/oder Dioden, die entsprechend der Ladungserzeugung und/oder Verschiebung die anfallenden Ladungsträger erfassen, die entweder als Ladungsmenge oder als entsprechender Strom registriert werden, Die Anordnung, Schaltung und Modulation der mindestens einen Gruppe von Aufnahmeelementen erfolgt dabei in der Weise, daß alle aufgrund von nicht modulierten und nicht zur Modulation des Aufnahmeelements korrelierten Signalwellen erzeugten Wellenenergieteilchen bei Integration des Meßsignals keinen Beitrag zum Meßsignal liefern, so daß der modulierte Signalanteil fast ausschließlich zum Messergebnis beiträgt.

Die Gruppen von Aufnahmeelementen bestehen mindestens aus je einem Aufnahmeelement, weisen vorzugsweise jedoch jeweils eine Vielzahl von Aufnahmeelementen auf.

Während die Detektorelektroden beim bekannten PMD normalerweise nur zum Auslesen des detektierten Signals dienen, liegt gemäß der vorliegenden Erfindung eine sog. Selbstmodulation (SM) des Detektors und damit ein sog. Selbstmodulations-PMD ( SM-PMD ) vor. Zur Ausführung dieser Selbstmodulation werden zwei Wege vorgeschlagen, die je nach Art des Detektors und der Meßaufgabe vorteilhaft sind.

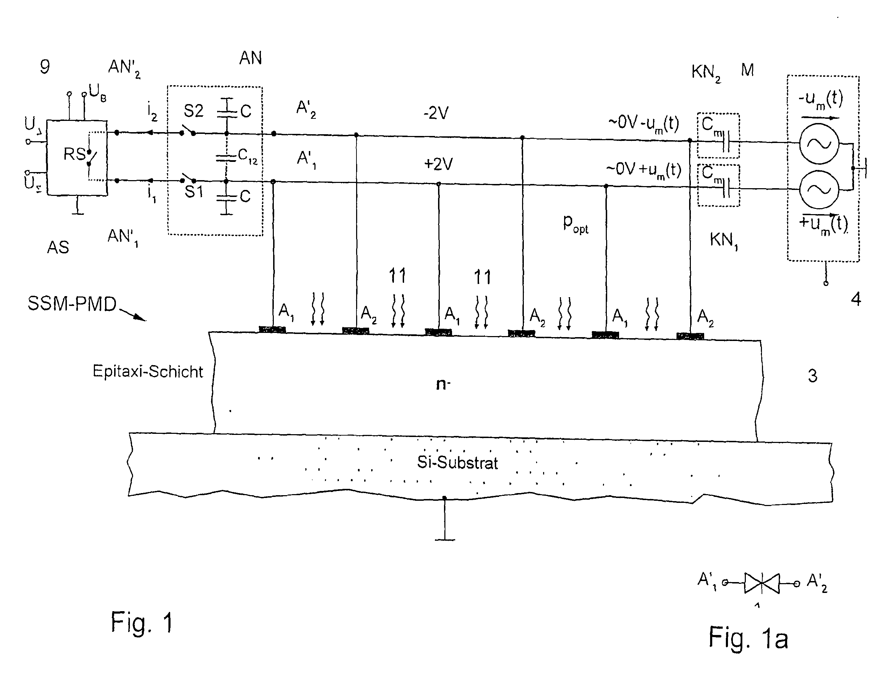

Beim symmetrischen SM-PMD (SSM-PMD), wie in Fig. 1 am Beispiel eines SM-PMD in Schottky- bzw. MSM (Metal Semiconductor Metal)-Technologie dargestellt, werden die beiden mehrfach parallel geschalteten Elektrodenarten, z.B. Anode oder Kathode, in einer symmetrischen Anordnung vorzugsweise über Kapazitäten Cm des Koppelnetzwerkes KN1 und KN2 mit einem Gegentakt-Modulationssignal $\pm$um(t) der Modulationsquelle M angesteuert und über ein abtastendes Auslesenetzwerk ausgelesen.

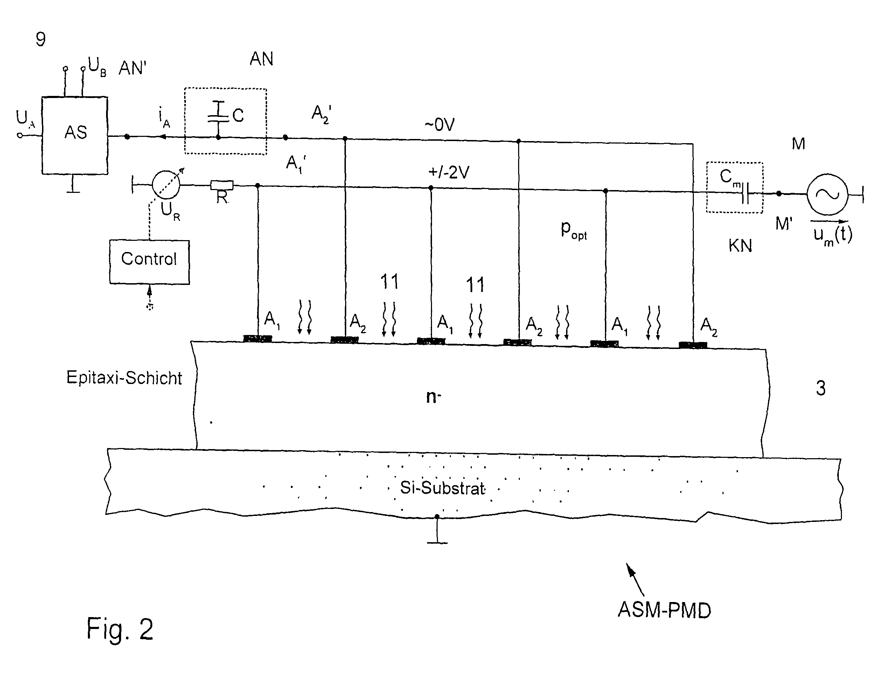

Beim asymmetrischen SM-PMD (ASM-PMD) wird nur einseitig die eine Elektrodenart z.B. A1 in Fig.2 aktiv moduliert, während die andere jeweils gegenüberliegende Elektrodenart A2 durch ein niederohmiges Auslesenetzwerk AN in Verbindung mit der Auswerteschaltung AS nur passiv am Mischprozeß beteiligt ist, wobei zugleich erreicht wird, daß die durch den Mischprozeß anfallenden Ladungen weitgehend ungestört vom Modulationssignal ausgelesen werden können.

Weitere Vorteile, Merkmale und Anwendungsmöglichkeiten der vorliegenden Erfindung werden deutlich anhand der folgenden Beschreibung einer bevorzugten Ausführungsform und der dazugehörigen Figuren. Es zeigen:

Fig. 1    einen Schnitt durch einen Teil eines erfindungsgemäßen planaren Photomischdetektors PMD mit symmetrischer Selbstmodulation und Auslese (SSM-PMD) in Schottkydioden-Technologie als Fingerstruktur mit abtastendem Auslesenetzwerk

Fig. 2 einen Schnitt durch einen Teil eines erfindungsgemäßen planaren Photomischdetektors PMD in Schottky-Technologie mit asymmetrischer Selbstmodulation und Auslese (ASM-PMD) in Scholtkydioden-Technik als Fingerstruktur

Fig. 3 einen Schnitt durch einen Teil eines erfindungsgemäßen planaren Photomischdetektors symmetrischer Selbstmodulation in PN-Technologie mit Kathodenauslese der Photoelektronen und mit zusätzlicher Modulation der Abschirmelektroden ME als Abschirmung der Auslesedioden, ausgeführt in einer 2-Phasenmischung (0, 90° bzw. I/Q)

Fig. 4 einen planaren Avalanche-Photomischdetektor,(APD-PMD) dargestellt im Querschnitt von streifenförmigen oder halbkugelförmigen Auslesedioden mit einer Lawineneffekt-Hochfeldzone, betrieben im Symmetrischen Selbst-Modulations-Modus

Fig. 5 eine zweiseitige orthogonale Streifenstruktur für 4Phasen-PMD-Betrieb als sog. Doppel-PMD

Fig. 6 ein MCP-PMD, ein Vakuum-PMD mit nachgeschalteter Mikrokanalplatten-Verstärkung

Fig. 7 ein Blockschaltbild eines Mikrowellen-Misch-Detektors (MMD) mit einen modulierten Antiparallelen Schottky-Diodenpaar als Ladungsschaukel und mit Symmetrischer Selbst-Modulation und zusätzlicher Mischverstärkung (Aktiv-MMD).

Fig. 8 eine Ausführung des MMD ohne Mischverstärkung mit einer asymmetrisch modulierten und ausgelesenen Patchantennenstruktur (Passiv-MMD)

Fig. 9 ein Aktiv-MMD mit einer asymmetrisch modulierten und ausgelesenen Patchantennenstruktur mit einer Mischverstärkung mit einem doppelt ausgeführten Gegentakt-Mischer zur Kompensation der Modulationssignale am Ausgang.

Figur 1 zeigt ein symmetrisches SM-PMD (SSM-PMD), das konkret in Schottky- bzw. MSM (Metal Semiconductor Metal)-Technologie dargestellt ist. Dabei werden die beiden mehrfach parallel geschalteten Elektrodenarten, z.B, Anode oder Kathode, in einer symmetrischen Anordnung vorzugsweise über Kapazitäten Cm des Koppelnetzwerkes KN1 und KN2 mit einem Gegentakt-Modulationssignal +um(t) der Modulationsquelle M angesteuert. Die einfallende Signalwelle 11, hier ein optisches Signal Popt (t), tritt zwischen den Ausleseelektroden, hier Metallelektroden als Anoden der Schottky-Übergänge zum photosensitiven Halbleitermaterial 3, in dasselbe (3) ein und erzeugt Photolöcher und Photoelektronen. Diese werden je nach der Phase bzw. Polarität des Modulationssignals der Elektrodenarten A1 bzw. A2 auch von diesen ausgelesen, Die relativ hohen Modulationsspannungen ±um(t) werden in dieser symmetrischen Schaltungsanordnung über Koppelnetzwerke KN1 und KN2 mit den gleichen Elektroden eingeleitet, mit denen auch die um viele Größenordnungen kleineren Misch- bzw.Korrelationssignale über die Auslesenetzwerke AN1 und AN2 und über eine nachgeschaltete Auswerteschaltung AS auch ausgelesenwerden, um danach, insbesondere bzgl. der Phasen- und Laufzeitdifferenz zwischen der Modulation der Signalwelle 11 und dem Misch- bzw. dem Modulationssignal um(t) ausgewertet zu werden. Diese zwangsläufige Verbindung stellt ein schwieriges Ausleseproblem dar, das die Anwendugsmöglichkeiten einschränkt.

Das Auslesenetzwerk AN trennt erfindungsgemäß das Modulationssignal und das Auslesesignal nicht über ein spektral trennendes Netzwerk, z.B. nicht über einen Tiefpaß, sondern über ein abtastendes Auslesenetzwerk AN in Verbindung mit der Auswerteschaltung AS, die über die Klemme 9 angesteuert werden kann. Diese liest nach einer geeigneten Integrationsdauer des Misch- und Korrelationsprozesses vorzugsweise unter Abschaltung der Modulation die bis dahin auf den Koppelkapazitäten Cm gespeicherten antisymmetrischen Ladungen kurzzeitig aus und führt sie vorzugsweise einem Differenzverstärkereingang der Auswerteschaltung AS zu, wobei unmittelbar danach die am Ausleseprozess beteiligte Schaltung vorzugsweise mit einer Reset-Schaltung in einen elektrischen Grundzustand für die nächste Messperiode zurückgesetzt wird.

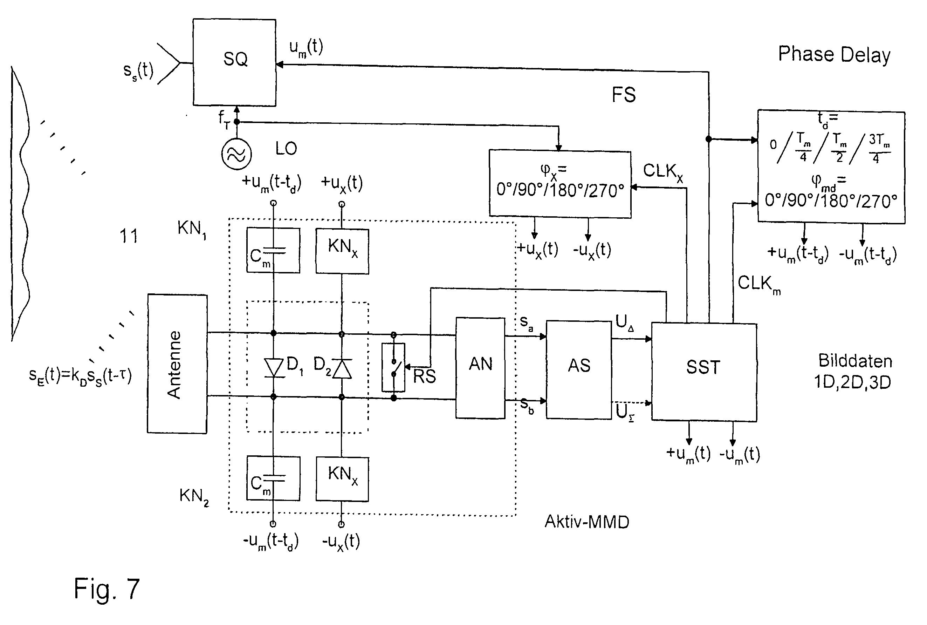

Die erforderlichen Abtast- und Reset-Steuerungsvorgänge werden vorzugsweise von einer zentralen Systemsteuerung SST wie in Fig. 7 veranschaulicht und vorzugsweise für viele PMD-Pixel parallel durchgeführt. Durch das vorteilhafte abtastende Ausleseverfahren wird u.a. erreicht, dass der Frequenzbereich des Modulationssignals prinzipiell nicht durch die Grenzfrequenz des Tiefpasses, die zur hinreichenden Signaltrennung mehrere Größenordnungen unter der des Modulationssignals liegen muss, eingeschränkt ist.

Die Vermeidung des Tiefpasses ist weiterhin für die halbleitertechnische Integrationsmöglichkeit des Auslesenetzwerks zusammen mit der Auswerteschaltung von großer wirtschaftlicher Bedeutung, da die großen erforderlichen Widerstandswerte und Kapazitätswerte und ihre erforderliche Pixelfläche praktisch nicht wirtschaftlich als System-on-Chip zu integrieren sind. Darüber hinaus wird das Rauschen der hochohmigen Widerstände vermieden.

Beim Asymmetrischen SM-PMD (ASM-PMD) wird nur einseitig die eine Elektrodenart z.B. A1 in Fig.2 aktiv moduliert, während die andere jeweils gegenüberliegende Elektrodenart A2 durch ein niederohmiges Auslesenetzwerk AN in Verbindung mit der Auswerteschaltung AS nur passiv am Modulationsvorgang beteiligt ist, wobei zugleich erreicht wird, dass die durch den Mischprozess anfallenden Ladungen weitgehend ungestört vom Modulationssignal ausgelesen werden können. Das geringe kapazitive Übersprechen des Modulationssignals von A1 auf die Ausleseelektroden A2 kann zusätzlich durch eine Kompensationsschaltung mit kapazitiver Kopplung des inversen Modulationssignals auf A2 verringert werden. Fig. 2 zeigt am Beispiel einer ASM-PMD-Struktur in Schottky-Technologie eine mögliche Vorrichtung zur Durchführung des Verfahrens. Das Auslesenetzwerk AN kann hierbei vorzugsweise aus einer Kapazität gegen Masse, meist als Streukapazität ohnehin wirksam, und aus einem Transimpedanzverstärker mit einer rücksetzbaren Kapazität Cf oder einer parallelen RC-Schaltung im Rückkopplungszweig eines invertierenden Verstärkers bestehen.

Ein besonderer Vorteil dieser PMD-Ausführung besteht in der Möglichkeit des aperiodischen und in der Bandbreite zu tiefen Frequenzen uneingeschränkten Mischens und Korrelierens.

Beiden Verfahren gemeinsam ist die hohe Selektivität und Empfindlichkeit bei der Auswertung des gesuchten korrelierten Signalanteils in der Signalwelle 11 und die hohe Unterdrückung nichtkorrelierter Signalanteile wie Rauschen und Hintergrundstrahlung: Gleichtaktladungen an beiden Ausleseelektroden $A_1'$, $A_2'$ in Fig. 1 werden durch die nachfolgende Differenzbildung der Auswerteschaltung gemäß dem Frequenzabstand vom Modulations- bzw. Abtastprozess unterdrückt.

Beim SSM-PMD ergeben die korrelierten Signalanteile gemäß der gewollten Korrelation zwischen der modulierten Signalwelle und dem Gegentakt-Modulationssignal automatisch Gegentaktströme bzw. -ladungen mit einer Differenz gemäß der Autokorrelationsfunktion.

Beim ASM-PMD mit einem einseitig an $A_1'$ angeschlossenen bipolaren Modulationssignal $u_m(t)$ ergeben die nichtkorrelierten Signalanteile auf der Ausleseelektrode $A_2'$ im Mittel gleich große positive und negative Ströme und heben sich beim Integrationsprozess gegenseitig auf. Die korrelierten Signalanteile dagegen ergeben gemäß der gewollten Korrelation zwischen Signalwelle und Modulationssignal automatisch einen gerichteten Strom bzw, nach der Integration eine Ladung bzw.Spannung $U_\Delta$ gemäß der Autokorrelationsfunktion.

Das am Beispiel des in Fig.1 und 2 in Schottky-Dioden-Technologie ausgeführte Misch- und Korrelationsprinzip in den beiden Varianten der Selbstmodulation kann auch in anderen Technologien realisiert werden, um spezielle Anforderungen der Problemstellung vorteilhaft zu erfüllen.

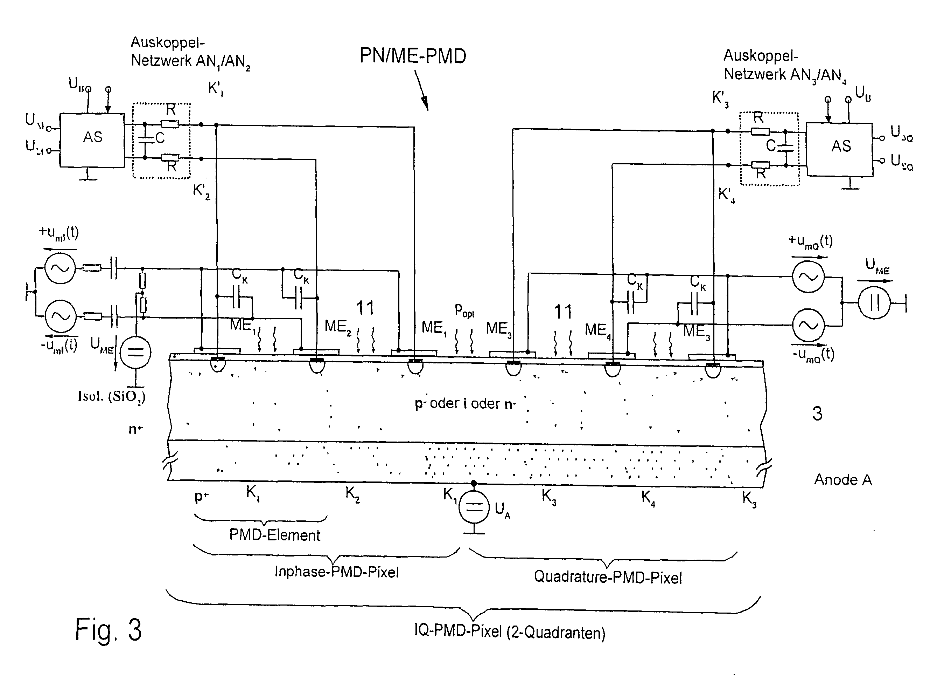

Wird z.B. keine hohe Schaltgeschwindigkeiten verlangt, so sind keine Schottky-Dioden erforderlich. An ihrer Stelle werden dann für A1 und A2 in Fig.1 und 2 erfindungsgemäß PN-Übergänge eingesetzt, wie in Fig. 3 z.B. durch entsprechende Kathodenstreifen gezeigt. Dies wird am Beispiel des SSM-PMD, hier als PN/ME-PMD bezeichnet, erläutert, wobei eine zusätzliche Verbesserung eingeführt wird. Dabei werden die zur Vermeidung des ungewollten Dunkelstroms bei Beleuchtung ohnehin notwendigen metallischen Abschirmungen der Auslesekathoden bzw. -anoden zugleich in den Modulationsprozess einbezogen. Dazu wird gemäß Fig. 3 der Katodenstreifen K1 bzw. K2 durch eine Metallelektrode ME1 bzw. ME2 gegen einfallendes Störlicht abgedeckt. Gleichzeitig werden die Modulationssignale kapazitiv über Ck sowohl auf die Kathodenstreifen K1, K2 als auch auf die Metallelektroden ME1, ME2 gekoppelt. Das mittlere Potential von K1 und K2 wird etwas höher als das mittlere Potential $U_{ME}$ in Fig. 3 von ME1 und ME2 gewählt, um für die Photoelektronen den Ausleseprozeß zu beschleunigen. Die übrigen Schaitungsteile entsprechen im Wesentlichen denen von Fig.1 und 2.

Ein praktisch wichtiger Unterschied zwischen der Schottky-Dioden- und der PN-Dioden-Ausführung besteht in dem Einfluß des Substrats bzw. der Gegenelektrode.

Im ersten Fall besteht bei Schottky-Kontaktstreifen auf der hochohmigem p- oder n- Epitaxischicht (3) praktisch kein Einfluß und über dem Substrat in Fig. 1 könnte auch eine Isolationsschicht eingefügt werden. Dann tragen sowohl Elektronen als auch Löcher zum Mischprozess bei.

Bei der SM-PMD-Ausführung mit PN-Dioden bestehen beide Möglichkeiten: 1. Das Substrat kann isoliert sein und die modulierte Umpolung der PN-Diodenstreifen führt zum Richtungswechsel des Photostroms aus Löchern und Elektronen. 2. Die Löcher werden, wie in Fig. 3 dargestellt, von der negativ mit UA vorgespannten Anode A gesammelt und tragen nicht zum Mischprozess bei. Hierbei werden höhere Schaltgeschwindigkeiten erreicht.

Das PN/ME-PMD in Fig.3 ist doppelt ausgeführt, um zwei Messungen der Korrelation parallel durchzuführen, die Inphase (1)-Messung links und die Quadratur (Q)-Messung rechts. Aus dem I- und Q-Wert lässt sich unmittelbar die Differenzphase zwischen der Signalwelle 11 und dem Modulationssignal $u_m(t)$ bestimmen..

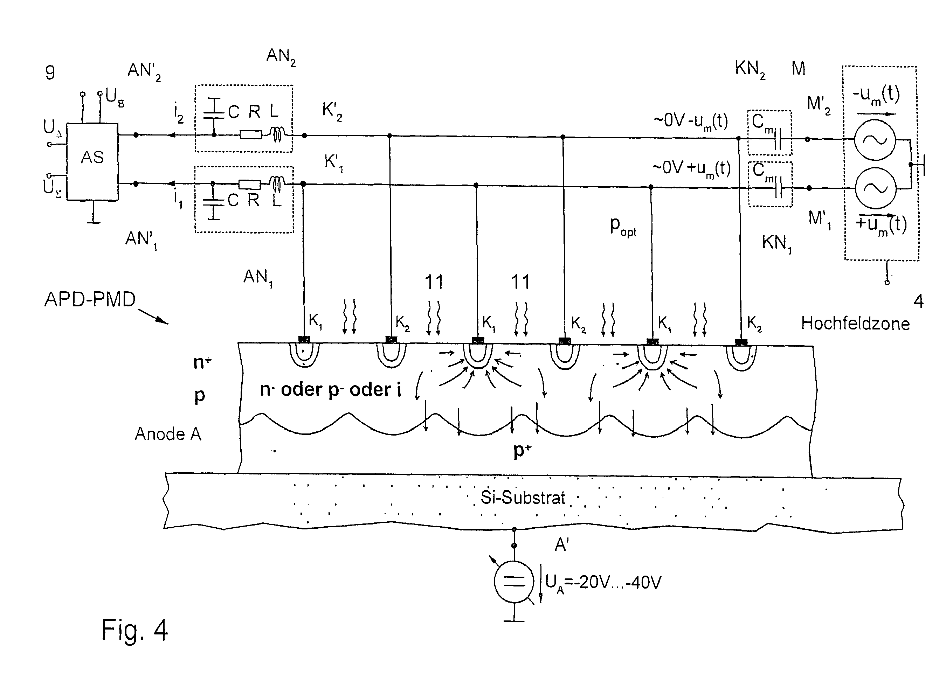

In einer weiteren Ausgestaltung der Erfindung der vorstehenden Ausführung werden in Fig. 4 die Kathodenstreifen K1 und K2 zusätzlich bei geeigneten Vorspannungen mit einer Hochfeldzone umgeben, um eine Photostromverstärkung durch den Lawineneffekt zu erzielen. Um möglichst gleichmäßige Felder zu erzeugen, kann die Anodenform zylindrisch den Kathodenstreifen angepasst werden.

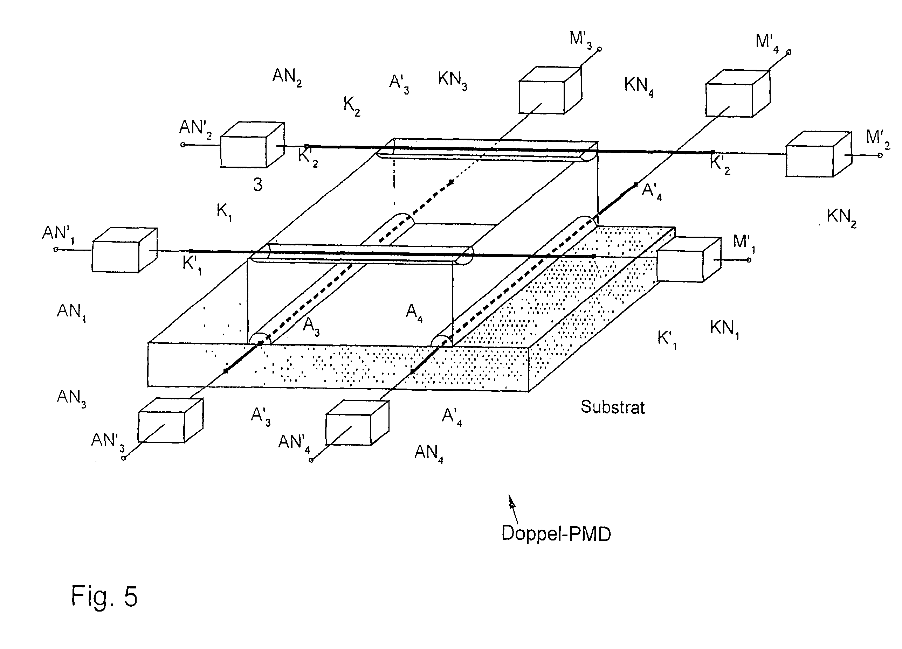

In Fig. 5 wird eine Ausführung der Erfindung dargestellt, die den Misch- und Korrelationsprozess sowohl an der Oberseite als auch auf der Unterseite des photosensitiven Materials 3 parallel durchführen kann. Dieses sog. Doppel-PMD weist in Fig. 5 durch die gegenüberliegenden Anoden und Kathoden die Struktur von mindestens zwei und vorzugsweise einer Vielzahl von parallel angeordneten PIN-Dioden auf, die vorzugsweise in zwei verschiedenen Arten betrieben werden kann.

1. Die gegenüberliegenden PMDs werden unhabhängig, d.h. mit zwei unterschiedlichen, vorzugsweise Gegentakt-Modulationssignalen moduliert, wodurch der z.B. als SMM-PMD ausgeführte Mischprozess eine doppelte Gegentaktmischung durchführt. Die beiden Mischprozesse beeinflussen sich dann nicht, wenn beide Gegentakt-Modulationssignale orthogonal sind. Sie beeinflussen sich trotz fehlender Signal-Orthogonalität auch dann nicht, wenn die Anordnung der gegenüberliegenden Elektroden orthogonal ist, wie im Ausführungsbeispiel in Fig. 5 gezeigt. In diesem Fall kann erfindungsgemäß die gleiche Signalwelle im Multiplexbetrieb z.B. bezüglich zweier Codierungen vermessen werden, wie z.B. bei IQ-Messungen bei CW-Modulation oder bei Diskriminator-AKF-Messungen bei PN-Codierung häufig erforderlich.

Eine Erhöhung des Qauntenwirkungsgrades kann durch Verspiegelung der Oberseite des Trägermaterials (Substrat) erzielt werden.

Eine spektrale Trennung unterschiedlicher eingestrahlter Lichtsignale kann dadurch erzielt werden, dass auf der lichtzugewandten Seite das z.B. vornehmlich blaue Lichtsignal mit typisch geringerer Absorptionslänge nahe der Oberfläche die "blaue" Photoladung erzeugt, während z.B. das vornehmlich rote Lichtsignal mit typisch längerer Absortionslänge tiefer eindringt und vornehmlich, vorzugsweise unterstützt durch eine Reflexionsschicht, auf der lichtabgewandten Seite der Hlableiterstruktur die "rote" Photoladung erzeugt.

2. Diese Doppel-PMD-Struktur ist in einer Ausführung als MSM-PMD-Struktur besonders vorteilhaft. Ausgehend von der beschriebenen Schottky- bzw. MSM-Struktur zu Fig. 1 und 2 werden die Kathodenstreifen K1 und K2 oben und die Anodenstreifen A3 und A4 unten in Fig. 5 durch Metallstreifen auf dem n- -Substrat ersetzt und könnten unabhängig, vorzugsweise aber in der oben beschriebenen Kooperation insbesondere in orthogonaler Geometrie und orthogonaler Modulation mit höchster Zeitauflösung parallel z.B. für Referenz und Ziel betrieben werden.

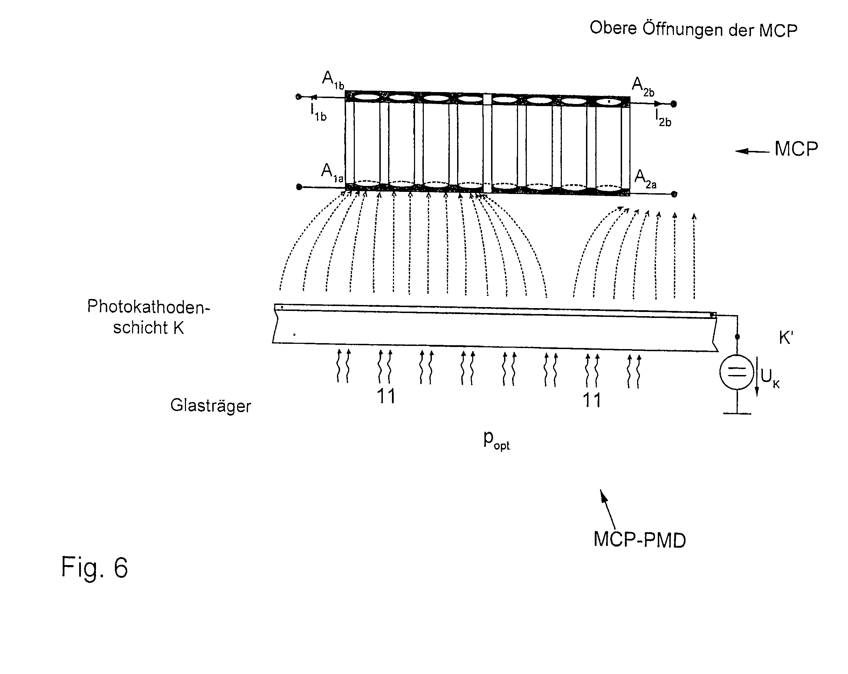

Eine weitere PMD-Ausführung des erfindungsgemäßen des Verfahrens erfolgt auf Basis eines Vakuum-PMD. Eine Photokathode auf einem Potential von z.B. Uk = -100 Volt empfängt die Signalwelle, Diese Signalwelle wird in eine entsprechende Signalwelle aus Photoelektronen PEL im Vakuum umgesetzt. Parallele Anodenstreifen A1a und A2a werden in einer solchen Vakuumphotodiode symmetrisch moduliert und könnten den von einer Photokathodenschicht K erzeugten Photostrom durch die zwei Elektrodenarten A1a und A2a in dieser Anodenebene a erfindungsgemäß über ein Auslesenetzwerk $AN_{1,2}$ auslesen. Dieser Aufwand ist nur gerechtfertigt, wenn zusätzlich eine hohe Verstärkung erzielbar ist. Diese wird gemäß Fig. 6 durch eine Mikrokanalplatte (Micro Channel Plate) MCP mit einer in entsprechenden Streifen metallisierten Stirnseite anstelle der Anodestreifen erzielt, die die Zuordnung der Photoelektronen zu den beiden Elektrodenarten wie bisher im Gegentakt über $u_m(t)$ modulieren. Nach diesem Mischprozess werden die Photoelektronen PEL streifenweise durch den Sekundärelektroneneffekt in den Mikrokanälen der MCP z.B. 1000-fach vervielfältigt und von den beiden Anodenstreifenarten A1b und A2b auf deren Rückseite der MCP in der zweiten Anodenebene b über A1 b, A2b ausgelesen. Dieser MCP-Photomischdetektor MCP-PMD weist neben der hohen Verstärkung auch eine hohe Bandbreite von über 1 GHz durch eine sehr schnelle Kanalzuordnung der Elektronen vor den Mikrokanälen, dem zugrunde liegenden Mischprozess, auf.

Die Auslese der verstärkten Photoelektronen geschieht entweder direkt über eine den modulierenden Anodenstreifen paarweise angepaßte Pixelstruktur mit Ladungsauslese oder zusätzlich mit einer nachfolgenden nachbeschleunigten und pixelweise direkten Auslese oder elektrooptisch über einen Leuchtschicht mit optischer PMD-Auslese z.B. gemäß Fig. 1 oder Fig. 2.

Das vorstehende erfindungsgemäße Misch- und Korrelationsprinzip wird vorstehend nur an Beispielen elektromagnetischer Signalwellen oberhalb von ca. 15 THz, bei dem die Paarbildung durch energiereiche Photonen technisch genutzt werden kann, ausgeführt. Es kann erfindungsgemäß auch auf Mikrowellen erweitert werden.

Für Mikrowellen unterhalb ca. 10 THz steht dieser photoelektrische Effekt nicht zur Verfügung. Dann wird ein Zugriff auf die Signalwelle vorzugsweise über die auf der Anteenenoberfläche von den Verschiebungsströmen induzierten Antennenströmen möglich. Das erfindungsgemäße Misch- und Korrelationsprinzip wird durch eine geeignete Ausführung der PMD-Ladungsschaukel auch auf Mikrowellen anwendbar und wird im folgenden anstelle Photonic Mixer Device (PMD) für Mikrowellen Microwave Mixer Device (MMD) genannt. Für die angestrebte Lösung für vorzugsweise sehr hohe, bis heute nicht erschlossene Frequenzbereiche sind vorzugsweise Patchantennen geeignet, die in einer Fingerstruktur die Energie aus einem gegenüber der Wellenlänge relativ großen Querschnitt des MMD-Pixeldurchmessers die Signalwellenenergie über die wellenlängenkohärente Verkopplung der Finger an nur einem Auslesekontaktpaar für eine geeignete Ladungsschaukel verfügbar macht. Eine mögliche Ausführung dieser Ladungsschaukel besteht darin, dass sowohl beim SSM-PMD als auch beim ASM-PMD z.B, die antiserielle Photodiodenstruktur von Fig. 1a durch eine einzige Antiparallelschaltung zweier Dioden, vorzugsweise Schottky-Dioden ersetzt und so ein SSM-MMD bzw. ein ASM-MMD gebildet wird. Dabei wird das Gegentakt-Antennensignal von der Gesammtstruktur der Patchantenne gepuffert und z.B. an den Klemmen der Dioden D1 und D2 in Fig. 7, die eine entsprechende Vorrichtung als Blockschaltbild mit dem SSM (Symmetrisch-Selbst-Modulierenden)- MMD zeigt, vorzugsweise kapazitiv eingekoppelt.

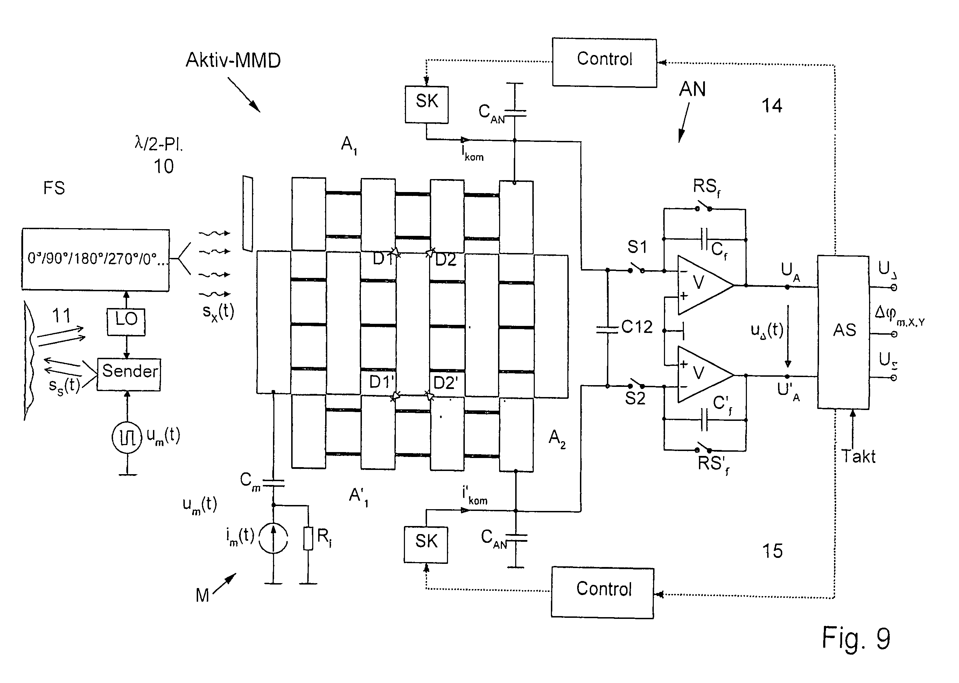

Zur Anwendung des erfindungsgemäßen Verfahren auf Mikrowellen wird die Signalwelle zunächst durch die Antenne in Fig. 7 in einen Antennenstrom umgewandelt, der aufgrund der wellenlängenkohärenten Verbindungen der Fingerstruktur für den relativ niederfrequenten Bereich des interessierenden Modulationssignals an den Klemmen von D1 und D2 zur Verfügung steht. Zur Ermittlung der Phase und Amplitude der Signalwelle dient vorzugsweise eine Gegentakt-Gleichrichterschaltung aus Schottkydioden, im einfachsten symmetrischen Fall ein Paar antiparalleler Schottkydioden $D_1$ und $D_2$ an einem vorzugsweise symmetrischen Antennenausgang vieler einzelner Antennenelemente. Das Modulationssignal $u_m(t)$ ist im einfachsten Fall und ohne Mischverstärkung ein Rechtecksignal von z.B. einigen MHz, eine Modulationsfrequenz, die für Abstandsmessungen mit Genauigkeiten im cm-Bereich ausreicht. Es schaltet den Mikrowellenträger der Signalquelle SQ über die Leitung 13 ein und aus. Für die Demodulation dieser MMD-Ladungsschaukel wird das entsprechende Modulationssignal als Gegentakt-Rechteckspannung $+u_m(t)$ über Koppelnetzwerke $KN_{m1}$ und $KN_{m2}$, vorzugsweise als Koppelkapazitäten $C_m$ und vorzugsweise in Serie mit einer den Frequenzen angepassten Induktivität $L_m$, zur induktiven Entkopplung der Mikrowellen ausgeführt, symmetrisch an das lung der Mikrowellen ausgeführt, symmetrisch an das Diodenpaar gelegt. Die mit unbekannter Laufzeit $\tau$ bzw. Phase $\varphi_m$ verzögerte Eingangs-Signalwelle $s_s(1-\tau)$ wird so je nach der Phasenlage der Diodenvorspannung einen Gleichrichterstrom durch die Diode $D_1$ oder $D_2$ verursachen und die beiden Koppelkapazitäter $C_m$ aufladen. Bei 90° Phasenverschiebung fließt aus Symmetriegründen der gleiche Gleichrichterstrom in die eine wie die andere Richtung, so dass der Summenstrom die Integrationsladung Null ergibt. Bei 0° Phasenverschiebung fließt ein maximaler Gleichrichterstrom in die eine Richtung, bei 180° Phasenverschiebung in die andere Richtung. Die zugehörige Korrelationsfunktion AKF über der Laufzeit weist bei Rechteckmodulation die bekannte Dreiecksform auf. Die Stromauslese der antisymmetrischen Ladungen von den Koppelkapazitäten $C_m$ erfolgt über das Auslesenetzwerk AN vorzugsweise als Abtastschaltung mit Reset ausgeführt und über Auswerteschaltung AS. Sie erfolgt mit so kurzen Integrationszeiten und so niederohmig, dass die integrierte Ladespannung auf den Koppelkapazitäten und entsprechende Rückströme über die Dioden zu vernachlässigen sind. Die nichtkorrelierte Hintergrundstrahlung führt aus Symmetriegründen zu Ladungen auf den Koppelkapazitäten $C_m$, die sich gegenseitig kompensieren und wird auf diese Weise bis auf korrigierbare Symmetriefehler z.B. durch eine Regeleinrichtung (Control) und eine Stromkompensation SK wie in Fig. 9 dargestellt automatisch ausgeregelt und unterdrückt.

Die Empfangseinrichtung besteht weiterhin aus der Antenne, vorzugsweise aus einer abbildenden Fresnel-Mikrowellenlinse oder einer Parabolspiegellinse für mindestens ein, vorzugsweise aus einem Array von MMD-Elementen, vorzugsweise als Bildpixelarray von Patch-Antennen ausgeführt, ferner aus dem Auslesenetzwerk AN, der Auswerteschaltung AS, der Systemsteuerung SST, dem vom Lokaloszillator LO mit der Trägerfrequenz $f_T$ gespeisten Sender SQ, der über die Phasensteuerung (Phase Delay) und die Zuleitung 13 mit $u_m$(t) moduliert wird. Sie enthält entsprechend Fig. 7 und 9 beim Aktiv-MMD eine Vorrichtung zur Mischverstärkung vorzugsweise mit einer fortlaufend getasteten Phasenstufe FS zur Erzeugung einer Frequenzverschiebung und mit dem Koppelnetzwerk KNx für das vorzugsweise vom Lokaloszillator LO abgeleiteten Mischsignals $\pm s_x$(t), das auf mindestens ein Diodenpaar übertragen wird. Während beim Passiv-MMD ohne Mischverstärkung z.B. im OOK (ON-OFF-Keying)-Modus gemessen wird, erlaubt der Aktiv-Modus z.B. Messungen im BPS(Bi Phase Shift)-Keying-Modus aber auch eine Vielzahl anderer üblicher Modulationsarten. Die unmittelbaren Mischergebnisse sa und sb eines MMD-Arrays und daraus abgeleitet die AKF-, Phasen- und Amplitudenwerte der Signalwelle werden vorzugsweise einer nachfolgenden Bildauswertung zugeführt.

Zur Ermittlung einer statischen Laufzeit ohne Mischverstärkung wird die Lage der Korrelationsfunktion AKF($\tau$) bzw. KKF($\tau$) = U$\Delta$($\tau$) vorzugsweise über 4 Phasenmessungen ermittelt. Dazu wird das Modulationssignal der MMD-Mischeinrichtung in vier Stufen $\varphi_{md}$ = 0° / 90° / 180° und 270° bzw. $t_d = 0\ /\ \dfrac{Tm}{4}\ /\ \dfrac{Tm}{2}\ /\ \dfrac{3Tm}{4}$ verzögert. Die Laufzeit ergibt sich als $\tau$ = 0,25Tm ($\Delta$lm/ ($\Delta$Re + $\Delta$lm)) mit $\Delta$lm = U$\Delta$ (90°) - U$\Delta$ (270°) und $\Delta$Re = U$\Delta$ (0°) - U$\Delta$ (180°).

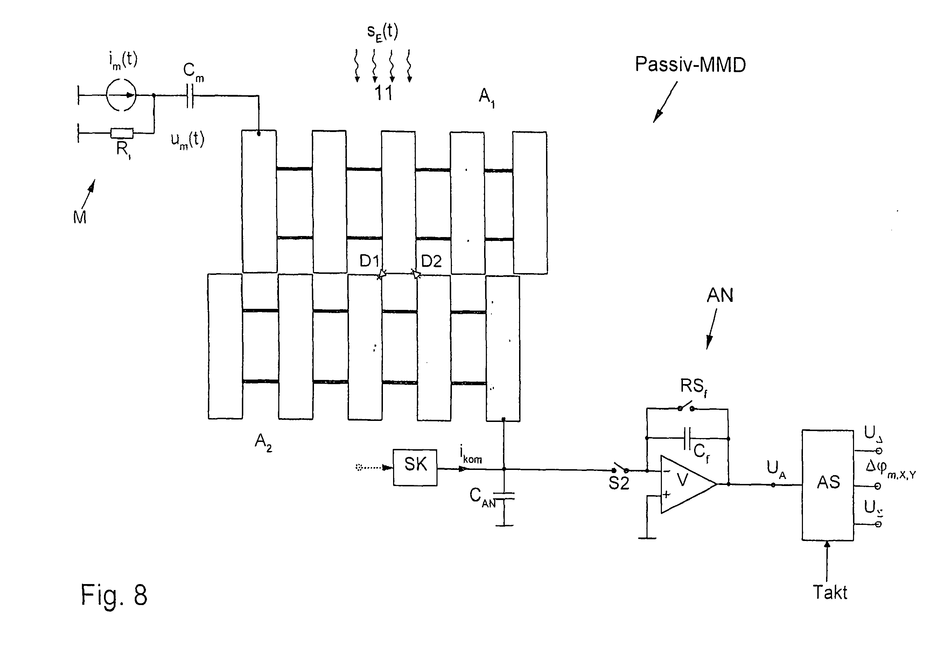

Fig. 8 zeigt vereinfacht ein Ausführungsbeispiel des MMD-Misch- und Korrelationsprinzips für ein Pixel einer passiven MMD-Radareinheit, d.h. für ein Passiv-MMD-Pixel ohne Mischverstärkung mit einer asymmetrischen Modulation und Auslese, also ein passives ASM-MMD.

Auf die Patchantennen-Fingerstruktur trifft die codierte Signalwelle 11 = $s_E(t)$ im Frequenzbereich von z.B. 10- 1000GHz. Die Breite der auf Resonanz abgestimmten Finger A1 und A2 beträgt $\lambda/2$ oder ein ungerades Vielfaches desselben. Die Länge ist praktisch beliebig und könnte im Fall gewünschter Polarisationsunabhängigkeit auch quadratisch ausgeführt werden. Das Modulationssignal $u_m(t)$ der Modulationsquelle M liegt über $C_m$ an der Fingerstruktur A1. Hier wird vorzugsweise ein relativ hoher Innenwiderstand der Modulationsquelle M bevorzugt, der durch die Ersatzschaltung aus $i_m(t)$ und den Innenwiderstand $R_1$ angedeutet wird. Das Misch- und Korrelationsprinzip beruht auch hier auf der modulierten Ladungsschaukel, hier auf der modulierten Leitfähigkeit der mindestens zwei Schottky-Dioden D1 und D2.

Das Übersprechen des Modulationssignals auf den Eingang des Auslesenetzwerks AN wird durch die Kapazität $C_{AN}$ und eine Stromkompensationsschaltung SK und den Strom $i_{kom}$, der vorzugsweise über die Auswerteschaltung AS auf minimales Übersprechen geregelt werden kann, kompensiert.

Die nichtkorrelierten Anteile der Signalwelle aufgrund des Mischprozesses ergeben bei dieser asymmetrischen Selbstmodulation (ASM-MMD) wiederum am Eingang des Auslesenetzwerks AN einen Wechselstrom, der zu Null integriert wird, während die korrelierten Anteile einen gerichteten Strom ergeben, der zur Autokorrelationsfunktion AKF integriert und über die Auswerteschaltung AS bzgl. der AKF-Werte, Phasen und Laufzeiten $\varphi_{m,x,y} = \omega\tau_{m,x,y}$ und der Amplituden ausgewertet wird. Ein Array von MMD-Pixeln liefert so über x,y ein Mikrowellen-3D-Bild,

Eine Anwendung des erfindungsgemäßen Verfahrens auf Mikrowellensignale mit Mischverstärkung wird in Fig. 9 dargestellt, das als sog. Aktiv-MMD bezeichnet wird, wiederum als asymmetrisches MMD ausgeführt. Die Gegentakt-Patchantenne entspricht in etwa einer Verdopplung derjenigen des Passiv-MMD aus Fig. 8, wobei die mittleren Fingerstrukturen $A_2$, $A_2$' in Fig. 9 verbunden sind. Zusätzlich zur Signalwelle 11 trifft ein Mischsignal $s_x(t)$, das vorzugsweise nicht moduliert ist, in gleicher Polarisation auf die untere und in umgekehrter Polarisatin (180° Phasenverschiebung) auf die obere Fingerstruktur. Dazu dient z.B. die $\lambda$/2-Platte 10 in Fig. 9. Bei phasenrichtiger Überlagerung von Empfangssignal $s_E(t)$ und Mischsignal $s_{,}(t)$ wird die MMD-Empfindlichkeit wesentlich gesteigert.

Die vereinten Fingerstrukturen A2 werden über die Modulationsquelle M wie in Fig. 8 relativ hochohmig moduliert.

Das Mischergebnis erscheint als Gegentaktsignal an den A1- und A1'-Fingem und wird über das Auslesenetzwerk AN vorzugsweise mit einem getasteten, doppelten Miller-Integrator ausgelesen, wobei der Masseanschluss der Plus-Eingänge entfallen und vorteilhaft durch eine hochohmige Brücke zu den Minus-Eingängen ersetz werden kann. Das obere und untere Modulationssignal liegt mit gleicher Polarität an den Eingängen von AN und führt theoretisch zu keiner ausgangsseitigen Aussteuerung für $U_\Delta(t)$. Unvermeidliche Unsymmetrien und Übersteuerungen werden durch zwei Maßnahmen neben Temperaturkonstanz und Symmetrie der Bauelemente und Spannungen erreicht:

1. In Kalibriermessungen werden die der Stromkompensationsschaltung SK über mindestens eine Regeleinrichtung (Control) so abgeglichen, dass die Fehlersignale an den Ausgängen $A_1$, $A_1$' minimiert werden. Die Kompensationsströme $i_{kom}$ und $i_{kom}$' enthalten einen Gleichanteil und einen den Einfluß des Modulationssignals kompensierenden Wechselanteil.

2. Die Abtastausleseschaltung verwendet vorzugsweise Integrationszeiten, die der Signalamplitude etwa umgekehrt proportional angepasst werden. Während des Ausleseprozesses wird die Modulation vorzugsweise unterbrochen.

Zur Ermittlung der gesuchten Phasenlage der AKF z.B. eines reflektierenden Objektes wird bei fehlender Bewegung und Dopplerverschiebung von Objekten vorzugsweise eine geeignete Frequenzverschiebung der Mischsignalfrequenz gegenüber der Sendesignalfrequenz erzeugt, wie zuvor zur Phasenstufe FS beschrieben. Die Fortschaltung der Phasen oberhalb der Shannonrate durch die diskrete Phaseschiebeeinheit FS mit einem Frequenzversatz führt zum Laufzeit-Scannen der AKF und damit zur Entfernungsbestimmung über der Bildtiefe.

Die vorstehend beschriebenen erfindungsgemäßen PMD-Lösungen und -Strukturen weisen insbesondere die im folgenden aufgezählten Vorteile gegenüber dem Stand der Technik auf:

1. Die optische Dämpfung des Lichtsignals durch die modulierenden Photogates der bekannten PMD-Strukturen entfällt vollständig. Die zusätzlich modulierten Metallelektroden ME bilden zugleich den erforderlichen Lichtschutz für die Ausleseelektroden und können als Metallelektroden höchste Modulationsfrequenzen übertragen.

2. Die fingerartigen Metall und Halbleiterstrukturen des erfindungsgemäßen SSM-PMD mit Abtastauslese und des ASM-PMD mit entkoppelter Auslese ist wesentlich einfacher, hoch integrierbar, hochempfindlich, ermöglicht wesentlich erweiterte Bandbreiten für Modulation- und Nutzsignale und erfordert weniger Prozessschritte zur Herstellung gegenüber dem Stand der Technik.

3. Da zwischen den gegenläufig modulierten Elektroden (z.B. $A_1$, $A_2$ und $ME_1$, $ME_2$) keine weiteren störenden Strukturen erforderlich sind, können die Elektrodenabstände und damit die Laufzeiten der Photoladungen entscheidend verringert werden.

4. Das Modulationsfeld wirkt unmittelbar in Richtung des gewünschten Photoladungstransportes. Dadurch ergibt sich eine effektivere Nutzung der Modulationsspannung mit dem Effekt der Erhöhung der Driftgeschwindigkeit und entsprechend höherer Modulationsbandbreite oder mit der Möglichkeit, die Modulationsleistung wesentlich zu verringern.

5. Die Sperrspannung der Photodioden beim PN/ME-PMD unterstützt den Ladungstransport für größere Eindringtiefen des Lichtsignals wesentlich, da sie bis zum Erreichen der Sättigungsfeldstärke und bis zur erforderlichen Ausdehnung der Raumladungszone einstellbar ist und so den Ladungstransport aus der Tiefe des photosensitiven Halbleitermaterials wesentlich beschleunigt. Hierdurch sind Bandbreiten erreichbar, die denen üblicher PIN-Photodioden entsprechen. Auf diese Weise eignet sich das erfindungsgemäße PN/ME-PMD auch für große Absorptionslängen.

6. Die Photodiodenstruktur des Schottky-PMD ist besonders vorteilhaft für geringe Eindringtiefen bzw. Absorptionslängen des Signalwelle. Bei Absorptionslängen im 1-10$\mu$m-Bereich und bei einer Streifenstruktur mit z.B. einer Gitterkonstanten von 5-10$\mu$m und Elektrodenbreiten von 1-5$\mu$m werden Modulationsbandbreiten von mehreren GHz erwartet.

7. Die planare Streifenstruktur ist in verschiedenen Technologien und Halbleitermaterialien nahezu unabhängig von der Pixelgröße durch die Streifenbreite und jeweilige Fingerlänge flexibel an die gestellten PMD-Anforderungen anpassbar.

8. Für den Spektralbereich von ca. 4...7 $\mu$m sowie 8...12 $\mu$m kann z.B. mit relativ hoher Quantenausbeute und hinreichender Schnelligkeit ein erfindungsgemäßes gekühltes PN/ME-PMD in InSb (Indium-Antimonid) sowie in HgCdTe-Technologie und damit eine entsprechend augensichere 3D-Kamera für höchste Frequenzen realisiert werden, die Nebel teilweise durchdringt.

9. Wenn es um die Vermessung insbesondere zweidimensionaler Wärmebilder ohne Laufzeitmessung geht, so kann eine erfindungsgemäße PMD-Kamera als virtuell gekühlte 2D-Kamera (PMD-Cooled Thermal Camera) dienen, indem die ankommende Wärmesignalwelle vor der PMD-Einstrahlung über ein Shutter moduliert wird, wobei das PMD-Pixelarray mit dem gleichen Modulationssignal moduliert wird, allerdings mit relativ kleinen Modulationsfrequenzen, da keine Laufzeiten gemessen werden. Auf diese Weise wird das Eigenrauschen und der Dunkelstrom der PMD-Wärmekamera um Größenordnungen verringert, so dass die übliche Kühlung entfallen kann. Das gleiche Prinzip gilt erfindungsgemäß auch für entsprechende 2D-Mikrowellen-Kameras für unbekannte Mikrowellensignale 11.

10. Die beschriebene PN/ME-PMD-Struktur ist vorteilhaft für eine Ausführung mit Ladungsträgermultiplikation (Avalanche Effekt) durch eine Hochfeldzone geeignet und erreicht als APD-PMD durch die Photostromverstärkung 10 - 100fach höhere Empfindlichkeiten.

11. Das vorgeschlagene Verfahren und die Vorteile der darauf beruhenden PMD-Komponenten und Anwendungen betreffen eine Vielfalt fortschrittliche Einsätze, z.B.:

- Phasenregelkreise (PLL) und CDMA (Code-Division-Multiple Access)-Empfänger
- dreidimensional vermessende und digitalisierende Photo- und Videokamera und als Elektronisches 3D-Roboterauge und 3D-Abstandsradar
- kombinierte Opto-Mikrowellen-3D-Kamerasysteme für die Fahrerassistenz und Unfallvermeidung, Kombiniert mit einem Inertialsystem für eine verbeserte 3D-Bildverarbeitung, weiterhin kombiniert mit dem GPS für Autopilotfunktionen
- 3D-PMD-Kamera als Optisches SAR (Synthetisches Apertur Radar)-Interferometer
- 2D-PMD-Kamera niedriger Modulationsfrequenz ohne Laufzeitmessung aber mit hoher Hintergrundlichtunterdrückung

um nur wenige Anwendungen aufzuführen.

**Patentansprüche**

1. Verfahren zur Erfassung und zur Verarbeitung der Amplitude und Phase von Signalwellen, wobei eine Signalquelle eine modulierte Signalwelle erzeugt, die, gegebenenfalls aufgrund von Reflexion und/oder Streuung verändert, von einer Empfangseinrichtung empfangen und dort mit einem Modulationssignal, das in einer wohl definierten Beziehung zu der Modulation der Signalwelle steht, durch eine Modulationsvorrichtung ohne den Träger der Signalwelle direkt demoduliert und bezüglich der Amplitude der modulierten Signalwelle und der Phasenbeziehung der Modulationsphase der Signalwelle und des Modulationssignals erfasst und ausgewertet wird, wobei in einem auf die Signalwellen empfindlichen Sensor einer Empfangseinrichtung durch die Signalwellenenergie unmittelbar oder mittelbar erzeugte Wellenenergieteilchen in einem Schaukelprozess mit einer Wellenenergieschaukel nach Maßgabe des Modulationssignals auf mindestens zwei unterscheidbare Aufnahmeelektroden des Sensors geleitet, erfasst, gegebenenfalls verstärkt und auf mindestens einem den Aufnahmeelektroden entsprechenden Auslese-Ausgang einer Ausleseeinheit als Summen- und/oder Korrelationssignal ausgegeben werden, **dadurch gekennzeichnet, dass** als Ausleseelektroden Gruppen von parallel geschalteten Aufnahmeelementen (A1, A2, K1, K2) verwendet werden, wobei mindestens eine der Gruppen von Aufnahmeelementen (A1, A2) direkt mit einem Modulationssignal beaufschlagt wird und das Ausgangssignal mindestens an einer Gruppe von Aufnahmeelementen, abgenommen wird.

2. Verfahren nach Anspruch 1, **dadurch gekenn-**

**zeichnet, dass** Gruppen von Aufnahmeelementen verwendet werden, die eine vorzugsweise ineinandergreifende Fingerstruktur haben.

3. Verfahren nach Anspruch 1 und 2, **dadurch gekennzeichnet, dass** die Aufnahmeelemente in Streifen- bzw. Fingerform ausgeführt sind und eine vorgesehene Sensorfläche durch eine entsprechend Anzahl und Länge solcher Aufnahmeelemente ausgefüllt wird.

4. Verfahren nach Anspruch 1 oder 2, **dadurch gekennzeichnet, dass** beide Gruppen von Aufnahmeelementen antisymmetrisch im Gegentakt mit dem Modulationssignal beaufschlagt werden

5. Verfahren nach Anspruch 4, **dadurch gekennzeichnet, dass** die Trennung des Modulationssignals und des Auslesesignals über ein abtastendes Auslesenetzwerk erfolgt.

6. Verfahren nach Anspruch 1 oder 2, **dadurch gekennzeichnet, dass** nur eine der Gruppen von Aufnahmeelementen mit dem Modulationssignal direkt beaufschlagt wird, wobei der zwischen den beiden Gruppen von Aufnahmeelementen fließende Strom direkt oder in Form sich sammelnder Ladung indirekt an einer anderen, nicht modulierten Gruppe von Aufnahmeelementen gemessen bzw. ausgewertet wird

7. Verfahren nach Anspruch 6, **dadurch gekennzeichnet, dass** das Auslesen der nicht modulierten Gruppe von Aufnahmeelementen durch ein niederohmiges Auslesenetzwerk, vorzugsweise unter kapazitiver und kompensierender Aufschaltung des inversen Modulationssignals, erfolgt.

8. Verfahren nach einem der Ansprüche 1 bis 5, **dadurch gekennzeichnet, dass** die durch die modulierte Signalwelle erzeugten Wellenenergieteilchen durch Vervielfachung verstärkt werden, wie z. B. durch den Avalanche-Effekt in einem Halbleitermaterial oder durch Sekundärelektronenvervielfachung im Vakuum.

9. Verfahren nach einem der Ansprüche 1 bis 6, **dadurch gekennzeichnet, dass** bei der symmetrischen Modulations-und Auslesestruktur sich die Modulationsfrequenz von der Trägerfrequenz hinreichend deutlich, und vorzugsweise um mindestens einen Faktor 100 unterscheidet.

10. Vorrichtung zur Erfassung und zur Verarbeitung der Amplitude und Phase von Signalwellen, mit einer Signalquelle, die eine modulierte Signalwelle erzeugt, einer Empfangseinrichtung für die gegebenenfalls aufgrund von Reflexion und/oder Streuung veränderte Signalwelle, einer Modulatiorisvorrichtung der Empfangseinrichtung, welche mit einem Modulationssignal, das in einer wohl definierten Beziehung zu der Modulation der Signalwelle steht, beaufschlagt wird, einem auf die Signalwellen empfindlichen Sensor der Empfangseinrichtung, in welchem durch die Signalwellenenergie unmittelbar oder mittelbar Wellenenergieteilchen erzeugt werden, wobei die Modulationsvorrichtung dafür ausgelegt ist, die Wellenenergieteilchen in einem Schaukelprozess mit einer Wellenenergieschaukel nach Maßgabe des Modulationssignals auf mindestens zwei Aufnahmeelektroden des Sensors zu leiten, und mit mindestens einem entsprechenden Auslese-Ausgang einer Ausleseeinheit für die Ausgabe eines Summenund/oder Korrelationssignals **dadurch gekennzeichnet, dass** die Aufnahmeelektroden jeweils aus einer Gruppe parallel geschalteter Aufnahmeelemente (A1, A2, K1, K2), bestehen, welche eine ineinander greifende Fingerstruktur aufweisen, wobei mindestens eine der Gruppen von Aufnahmeelementen (A1) unmittelbar mit der Modulationsvorrichtung (M) verbunden ist.

11. Vorrichtung nach Anspruch 10, **dadurch gekennzeichnet, dass** die Aufnahmeelemente fingerartige, vorzugsweise ineinandergreifende Strukturen aufweisen.

12. Vorrichtung nach Anspruch 10 oder 11, **dadurch gekennzeichnet, dass** zwei Gruppen von Aufnahmeelementen vorgesehen sind, die mit je einem von zwei im Gegentakt modulierten Anschlüssen der Modulationsvorrichtung verbunden sind.

13. Vorrichtung nach Anspruch 12, **dadurch gekennzeichnet, dass** für beide Gruppen von Aufnahmeelementen ein abtastendes Auslesenetzwerk vorgesehen ist, welches vorzugsweise über einen Differenzverstärker die auf Koppelkapazitaten zwischengespeicherten Ladungen der jeweiligen Gruppe von Aufnahmeelementen ausliest.

14. Vorrichtung nach einem der Ansprüche 10 oder 11, **dadurch gekennzeichnet, dass** zwei Gruppen von Aufnahmeelementen vorgesehen sind, von denen nur eine mit der Modulationsvorrichtung verbunden ist.

15. Vorrichtung nach Anspruch 14, **dadurch gekennzeichnet, dass** zur Vermeidung eines kapazitiven Übersprechens des Modulationssignals auf die nicht modulierte Gruppe von Ausleseelektroden eine kapazitive Kompensationsschaltung des inversen Modulationssignals auf diese Gruppe vorgesehen ist.

16. Vorrichtung nach einem der Ansprüche 10 bis 15, **dadurch gekennzeichnet, dass** die Sensoren auf elektromagnetische Wellen empfindlicher Halbleiter (Photohalbleiter) sind.

17. Vorrichtung nach Anspruch 16, **dadurch gekennzeichnet, dass** die Aufnahmeelemente mit Elektronenvervielfachern verbunden sind oder Avalanche-Halbleiterelemente aufweisen.

18. Vorrichtung nach einem der Ansprüche 10 bis 17, **dadurch gekennzeichnet, dass** die Signalquelle eine modulierbare Quelle elektromagnetischer Strahlung ist, die in einem vorzugsweise schmalen Spektralbereich modulierte elektromagnetische Wellen aus dem Spektrum vom Bereich der Radiowellen bis hin zum fernen Infrarot emittiert.

19. Vorrichtung nach Anspruch 18, **dadurch gekennzeichnet, dass** als Aufnahmeelemente für Mikrowellen Patchantennen vorgesehen sind, deren Ausgänge über Diodenpaare gleich gerichtet und mit Koppelkondensatoren verbunden sind.

20. Verfahren nach Anspruch 1 und 2, 3, 18 oder 19, **dadurch gekennzeichnet, dass** mindestens zwei Gruppen von Patchantennen, die jeweils wellenlängenkohärent miteinander verbunden sind und wobei die mindestens zwei Gruppen über mindestens ein antiparalleles Diodenpaar verbunden sind, eine Signalwelle empfangen, wobei die Signalwelle durch das antiparallele Diodenpaar im Takt mindestens eines Ober eine Koppelkapazität auf eine Gruppe eingeleitetes Modulationssignal gleichrichtet wird, und wobei die gleichrichtete bzw. gemischte Signalwelle an der mindestens einen anderen Gruppe von Patchantennen ausgelesen wird.

**Claims**

1. Process for detecting and processing the amplitude and phase of signal waves, wherein a signal source generates a modulated signal wave which, optionally modified by reflection and/or scattering, is received by a receiving apparatus and directly demodulated therein, using a modulation signal, which has a well-defined relationship to the modulation of the signal wave, is directly demodulated by a modulation device without the carrier of the signal wave, and is optionally also detected and evaluated with respect to the amplitude of the modulated signal wave and the phase relationship of the modulation phase of the signal wave and of the modulation signal, wherein in a sensor in a receiving apparatus, sensitive to the signal wave, wave energy particles directly or indirectly generated by means of the signal wave energy, in an oscillation process with a wave energy oscillator matching the modulation signal, are fed to at least two distinguishable receiving electrodes of the sensor, detected, optionally amplified, and transmitted to at least one readout output of a readout unit corresponding to the receiving electrodes in the form of a summation and/or correlation signal, **characterized in that**, as readout electrodes, groups of parallel-switched receiving elements (A1, A2, K1, K2) are used, wherein at least one of the groups of receiving elements (A1, A2) is directly loaded with a modulation signal and the output signal is received at least on one group of receiving elements.

2. Process according to claim 1, **characterized in that** groups of receiving elements are used, which preferably have an interlocking finger structure.

3. Process according to claim 1 or 2, **characterized in that** the receiving elements are constructed in strip/finger form, and a provided sensor surface is filled out by a corresponding number and length of such receiving elements.

4. Process according to claim 1 or 2, **characterized in that** both groups of receiving elements are antisymmetrically loaded in push-pull with the modulation signal.

5. Process according to claim 4, **characterized in that** the separation of the modulation signal and the readout signal takes place via a scanning readout network.

6. Process according to claim 1 or 2, **characterized in that** only one of the groups of receiving elements is directly loaded with the modulation signal, wherein the current flowing between the two groups of receiving elements is directly, or in the form of accumulating charge indirectly measured/evaluated against another non-modulated group of receiving elements.

7. Process according to claim 6, **characterized in that** the readout of the non-modulated group of receiving elements takes place via a low-resistance readout network, preferably under capacitive and compensating addition of the inverse modulation signal.

8. Process according to one of claims 1 to 5, **characterized in that** the wave energy particles generated by the modulated signal wave are amplified by multiplication, as e.g. by the avalanche effect in a semiconductor material or by secondary electron multiplication in a vacuum.

9. Process according to one of claims 1 to 6, **characterized in that** in the symmetrical modulation and readout structure the modulation frequency differs sufficiently clearly from the carrier frequency, and preferably by at least a factor of 100.

10. Device for detecting and processing the amplitude and phase of signal waves, with a signal source which generates a modulated signal wave, a receiving apparatus for the signal wave optionally modified by reflection and/or scattering, a modulation device of the receiving apparatus, which is loaded with a modulation signal, which has a well-defined relationship to the modulation of the signal wave, a sensor of the receiving apparatus, sensitive to the signal waves, in which wave energy particles are directly or indirectly generated by means of the signal wave energy, wherein the modulation device is designed to feed the wave energy particles in an oscillation process with a wave energy oscillator matching the modulation signal, to at least two receiving electrodes of the sensor, and with at least one corresponding readout output of a readout unit for the transmission of a summation and/or correlation signal, **characterized in that**, the receiving electrodes each consist of a group of parallel-switched receiving elements (A1, A2, K1, K2), which have an interlocking finger structure, wherein at least one of the groups of receiving elements (A1) has a direct connection with the modulation device (M).

11. Device according to claim 10, **characterized in that** the receiving elements have finger-type, preferably interlocking structures.

12. Device according to claim 10 or 11, **characterized in that** two groups of receiving elements are provided, which are each connected with one of two push-pull modulated terminals of the modulation device.

13. Device according to claim 12, **characterized in that** for both groups of receiving elements, a scanning readout network is provided, which preferably reads out the charges of the respective groups of receiving elements, temporarily stored on coupling capacitances, via a differential amplifier.

14. Device according to one of claims 10 or 11, **characterized in that** two groups of receiving elements are provided, only one of which is connected with the modulation device.

15. Device according to claim 14, **characterized in that** to avoid a capacitive crosstalk of the modulation signal on the non-modulated group of readout electrodes a capacitive compensation circuit of the inverse modulation signal on this group is provided.

16. Device according to one of claims 10 to 15, **characterized in that** the sensors are semiconductors sensitive to electromagnetic waves (photo semiconductors).

17. Device according to claim 16, **characterized in that** the receiving elements are connected with electron multipliers or have avalanche-semiconductor elements.

18. Device according to one of claims 10 to 17, **characterized in that** the signal source is a modulatable source of electromagnetic radiation, which within a preferably narrow spectral range emits modulated electromagnetic waves from the spectrum from the radio wave range to far infrared.

19. Device according to claim 18, **characterized in that** the patch antennae are provided as receiving elements for microwaves, whose outputs are rectified via diode pairs and connected with coupling capacitors.

20. Process according to claims 1 and 2, 3, 18 or 19, **characterized in that** at least two groups of patch antennae, which are in each case connected with each other in a wavelength-coherent manner, and in which the at least two groups are connected via at least one antiparallel diode pair, receive a signal wave, wherein the signal wave is rectified by the antiparallel diode pair in time with at least one modulation signal introduced via a coupling capacitance onto a group, and wherein the rectified/mixed signal waves are read out at the at least one other group of patch antennae.

## Revendications

1. Procédé d'enregistrement et de traitement de l'amplitude et de la phase d'ondes porteuses d'informations, une source de signaux produisant une onde porteuse d'information modulée laquelle, éventuellement modifiée du fait d'une réflexion et/ou dispersion, est reçue par un appareil de réception et y est directement démodulée par un dispositif de modulation sans le support de l'onde porteuse d'informations au moyen d'un signal de modulation présentant une relation bien définie par rapport à la modulation de l'onde porteuse d'informations, et est enregistrée et analysée en fonction de l'amplitude de l'onde porteuse d'informations modulée et de la relation de phase de la phase de modulation de l'onde porteuse d'informations et du signal de modulation, des particules d'énergie d'onde produites directement ou indirectement par l'énergie des ondes porteuses d'information étant acheminées, enregistrées, éventuellement amplifiées dans un capteur sensible aux ondes porteuses d'information d'un appareil de réception au cours d'un processus d'oscillation avec une oscillation d'énergie d'onde conforme au signal de modulation sur au moins deux électrodes réceptrices différentiables du capteur et émises vers au moins une sortie de lecture d'une unité de lecture correspondant aux électrodes réceptrices en tant que signal de somme et/ou de corrélation, **caractérisé en ce que** des groupes d'éléments récepteurs (A1, A2, K1, K2) montés en parallèle sont utilisés comme électrodes de lecture, au moins un des groupes d'éléments récepteurs (A1, A2) étant directement soumis à l'effet d'un signal de modulation et le signal de sortie étant recueilli au moins sur un groupe d'éléments récepteurs.

2. Procédé selon la revendication 1, **caractérisé en ce qu'**on utilise des groupes d'éléments récepteurs présentant une structure de doigts s'engrenant de préférence les uns dans les autres.

3. Procédé selon les revendications 1 et 2, **caractérisé en ce que** les éléments récepteurs sont conçus sous forme de bandes ou de doigt et une surface de capteur prévue est remplie par un nombre et une longueur correspondants de ces éléments récepteurs.

4. Procédé selon la revendication 1 ou 2, **caractérisé en ce que** les deux groupes d'éléments récepteurs sont soumis à l'effet du signal de modulation de manière antisymétrique en push-pull.

5. Procédé selon la revendication 4, **caractérisé en ce que** la séparation du signal de modulation et du signal de lecture s'effectue par un réseau de lecture à balayage.

6. Procédé selon la revendication 1 ou 2, **caractérisé en ce qu'**un seul des groupes d'éléments récepteurs est soumis à l'influence directe du signal de modulation, le courant circulant entre les deux groupes d'éléments récepteurs étant mesuré ou analysé directement ou sous forme d'une accumulation de charge indirectement sur un autre groupe non modulé d'éléments récepteurs.

7. Procédé selon la revendication 6, **caractérisé en ce que** la lecture du groupe non modulé d'éléments récepteurs s'effectue par un réseau de lecture de faible impédance, de préférence sous l'effet d'une entrée en ligne capacitive et à compensation du signal de modulation inverse.

8. Procédé selon l'une quelconque des revendications 1 à 5, **caractérisé en ce que** les particules d'énergie d'onde produites par l'onde porteuse d'informations modulée sont amplifiées par multiplication, comme par exemple par l'effet d'avalanche dans un matériau semi-conducteur ou par une multiplication secondaire d'électrons dans le vide.

9. Procédé selon l'une quelconque des revendications 1 à 6, **caractérisé en ce que** pour la structure de modulation et de lecture symétrique, la fréquence de modulation se différencie suffisamment clairement de la fréquence porteuse, et de préférence d'au moins un facteur 100.

10. Dispositif d'enregistrement et de traitement de l'amplitude et de la phase d'ondes porteuses d'informations comprenant une source de signaux produisant une onde porteuse d'informations modulée, un appareil de réception pour l'onde porteuse d'informations éventuellement modifiée du fait d'une réflexion et/ou dispersion, un dispositif de modulation de l'appareil de réception soumis à l'effet d'un signal de modulation présentant une relation bien définie par rapport à la modulation de l'onde porteuse d'informations, un capteur sensible aux ondes porteuses d'informations de l'appareil de réception dans lequel des particules d'énergie d'onde sont produites directement ou indirectement par l'énergie des ondes porteuses d'informations, le dispositif de modulation étant conçu pour acheminer les particules d'ondes porteuses d'informations au cours d'un processus d'oscillation avec une oscillation d'énergie d'onde conforme au signal de modulation sur au moins deux électrodes réceptrices différentiables du capteur et comprenant au moins une sortie de lecture correspondante d'une unité de lecture pour la sortie d'un signal de somme et/ou de corrélation, **caractérisé en ce que** les électrodes réceptrices sont constituées respectivement d'un groupe d'éléments récepteurs (A1, A2, K1, K2) montés en parallèle et comprenant une structure de doigts s'engrenant les uns dans les autres, au moins un des groupes d'éléments récepteurs (A1) étant relié directement au dispositif de modulation (M).

11. Dispositif selon la revendication 10, **caractérisé en ce que** les éléments récepteurs comprennent des structures de type doigt, s'engrenant de préférence les unes dans les autres.

12. Dispositif selon la revendication 10 ou 11, **caractérisé en ce que** deux groupes d'éléments récepteurs reliés chacun à un parmi deux raccordements modulés en pull-push du dispositif de modulation sont prévus.

13. Dispositif selon la revendication 12, **caractérisé en ce qu'**un réseau de lecture à balayage lisant de préférence les charges stockées temporairement sur des capacités de couplage du groupe respectif d'éléments récepteurs par l'intermédiaire d'un amplificateur différentiel est prévu pour les deux groupes d'éléments récepteurs.

14. Dispositif selon l'une quelconque des revendications 10 ou 11, **caractérisé en ce que** deux groupes d'éléments récepteurs sont prévus, parmi lesquels un seul est relié au dispositif de modulation.

**15.** Dispositif selon la revendication 14, **caractérisé en ce que** pour éviter une diaphonie capacitive du signal de modulation sur le groupe non modulé d'électrodes de lecture, un circuit de compensation capacitif du signal de modulation inverse est prévu sur ce groupe.

**16.** Dispositif selon l'une quelconque des revendications 10 à 15, **caractérisé en ce que** les capteurs sont des semi-conducteurs (éléments photosensibles à semi-conducteur) sensibles aux ondes électromagnétiques.

**17.** Dispositif selon la revendication 16, **caractérisé en ce que** les éléments récepteurs sont reliés à des multiplicateurs d'électrons ou comprennent des éléments semi-conducteurs en avalanche.

**18.** Dispositif selon l'une quelconque des revendications 10 à 17, **caractérisé en ce que** la source de signaux est une source modulable d'un rayonnement électromagnétique émettant dans un domaine spectral de préférence étroit des ondes électromagnétiques modulées à partir du spectre du domaine des ondes radio jusqu'à l'infrarouge lointain.

**19.** Dispositif selon la revendication 18, **caractérisé en ce que** des antennes patch dont les sorties sont orientées dans la même direction et reliées à des condensateurs de couplage par des paires de diodes sont prévues comme éléments récepteurs pour des micro-ondes.

**20.** Procédé selon les revendications 1 et 2, 3, 18 ou 19, **caractérisé en ce qu'**au moins deux groupes d'antennes patch respectivement reliées les unes aux autres avec une cohérences des longueurs d'onde et les au moins deux groupes étant reliés par au moins une paire de diodes antiparallèles recevant une onde porteuse d'informations, l'onde porteuse d'informations étant orientée dans le même sens par la paire de diodes antiparallèles en cadence d'au moins une capacité de couplage sur un groupe de signal de modulation envoyé, et l'onde porteuse d'informations orientée dans la même direction ou mélangée étant lue sur le ou les autres groupes d'antennes patch.

Fig. 1

Fig. 1a

Fig. 2

EP 1 332 594 B1

Fig. 3

Fig. 4

Fig. 5

Obere Öffnungen der MCP

$A_{1b}$          $A_{2b}$

$I_{1b}$          $I_{2b}$

← MCP

$A_{1a}$          $A_{2a}$

Photokathodenschicht K

K'

Glasträger

11      11

$U_K$

$p_{opt}$

MCP-PMD

Fig. 6

EP 1 332 594 B1

Fig. 7

Fig. 8

Fig. 9

**EP 1 332 594 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 19635932

### In der Beschreibung aufgeführte Nicht-Patentliteratur

- Computer Vision. Academic Press, vol. I, 474ff

- **Veröffentlichung Schwarte.** Neuartige 3D-Visionssysteme auf der Basis Layoutoptimierter PMD-Strukturen. *Technisches Messen TM,* 01. Juli 1998, vol. 65 (7/8), 264-271